# FASCICULE DE BREVET EUROPEEN

(11) **EP 3 283 594 B1**
(45) Date de publication et mention de la délivrance du brevet: **27.11.2019**
(21) Numéro de dépôt: 16718223.7
(22) Date de dépôt: 07.04.2016
(51) Int. Cl.: C09K 5/06, C08J 9/00, F28D 20/02

(54) **MATERIAU POUR LE STOCKAGE THERMIQUE**
WÄRMESPEICHERMATERIAL
HEAT STORAGE MATERIAL

(30) Priorité: 13.04.2015 FR 1553213
(43) Date de publication de la demande: 21.02.2018
(73) Titulaire: Hutchinson, 75008 Paris (FR)
(72) Inventeur: PREBE, Arnaud, 45200 Amilly (FR); DUFOUR, Bruno, 77430 Champagne sur Seine (FR); CHOPARD, Fabrice, 38400 Saint Martin d'Heres (FR); GAROIS, Nicolas, 45200 Amilly (FR); SONNTAG, Philippe, 77210 Avon (FR)
(74) Mandataire: Corizzi, Valérie
(86) Numéro de dépôt international: PCT/EP2016/057554
(87) Numéro de publication internationale: WO 2016/165999

(56) Documents cités:
- US-A1- 2002 147 242
- US-A1- 2003 220 432
- US-A1- 2014 039 082
- US-B1- 7 316 262
- 3M Mercados Industriales: "El jumbo de Esponja Scotch-Brite(TM) Extra", , 1 janvier 2009 (2009-01-01), XP055246323, Extrait de l'Internet: URL:http://www.pampaindustrial.com/img/pro duct_content/245_TD.pdf [extrait le 2016-02-01]

## Description

L'invention concerne un nouveau matériau pour le stockage thermique présentant des propriétés améliorées, ce matériau comprenant un support en matériau poreux thermiquement conducteur, dont les pores sont remplies d'un matériau à changement de phase (MCP). L'invention concerne également un procédé pour la fabrication de ce matériau et ses utilisations.

### Etat de la technique antérieure

Les matériaux permettant le stockage thermique sont utilisés dans différentes applications. On les retrouve dans des domaines tels que le contrôle de la température par inertie dans le bâtiment ou encore dans l'exploitation des sources d'énergie renouvelables à caractère intermittent. On peut aussi envisager d'exploiter la chaleur générée par les appareils électriques comme les ordinateurs, les serveurs, ou encore les batteries, à la condition que le matériau capable de stoker l'énergie soit également isolant électrique.

Pour réaliser un matériau permettant le stockage d'énergie thermique, on retrouve dans la littérature majoritairement trois procédés.

Le premier procédé consiste à encapsuler le MCP ou à l'adsorber sur un support avant sa formulation dans une composition de matière.

Par exemple, US20130298991 décrit l'utilisation de charges minérales adsorbant le MCP. Le mélange est ensuite formulé avec un liant pour ciment et un solvant aqueux pour produire un ciment contenant le MCP. L'adsorption sur la charge est une étape supplémentaire dans la fabrication du ciment.

WO03/099427, US5456852, US5916478 et WO2007/107171 décrivent des méthodes d'encapsulation de MCP de façon à former des particules dotées d'un cœur de MCP et d'un enrobage polymérique. Ces particules sont ensuite dispersées dans un support. Dans tous les cas, aucune charge conductrice thermique n'est incorporée dans le support et la conductivité thermique de ces matériaux n'est pas évaluée. Cette méthode présente l'inconvénient de nécessiter des étapes complexes de synthèse des coques polymériques. Les matériaux à base de MCP encapsulés dans des matrices polymériques ne sont pas facilement recyclables.

Un second procédé implique de mélanger directement le MCP avec un liant, ou de mélanger le MCP avec un monomère qui est ensuite polymérisé de façon à former un liant, en présence du MCP. Le liant assure la cohésion du matériau.

Par exemple WO03085346 décrit un revêtement mural contenant des particules de MCP qui sont adsorbées dans une couche de revêtement mural de type polymérique, ou fixées à une couche adsorbante du revêtement mural.

EP693542 décrit une composition ayant comme base des MCP, de l'eau et des polymères réticulables et gonflant dans l'eau. Le mélange donne une composition dans laquelle le MCP est dispersé dans un hydrogel. WO2007/040395 décrit la polymérisation de monomères dont au moins un est lié directement à un MCP.

Dans tous ces matériaux, le MCP est associé à un support non conducteur thermique, aussi la propagation de la chaleur au sein du support de/vers les MCP est très réduite. Cette conception du matériau entraine une faible réactivité du système aux changements de température.

FR2993894 et US20050020768 décrivent des matériaux obtenus à partir d'une matrice à base silicone et de MCP. Dans FR2993894 il est enseigné d'incorporer des charges thermiquement conductrices dans la matrice siliconée. Toutefois les quantités de charges thermiquement conductrices étant faibles, les valeurs de conductivité thermique obtenues sont aussi faibles. Les matériaux de l'art antérieur étant obtenus à partir de précurseurs liquides qui sont formulés puis réticulés ne sont pas recyclables. Enfin, la morphologie des matériaux de l'art antérieur est différente de celle des matériaux de l'invention qui présentent la particularité d'être constitués d'un support poreux dont les pores accueillent le MCP. US20050020768 enseigne une dispersion de MCP fine et divisée dans une matrice siliconée réticulée, tandis que le procédé de l'invention donne accès à un matériau comprenant une phase continue de MCP si on le souhaite.

WO200662610 décrit le mélange de MCP avec des matériaux thermoplastiques élastomères du type polyéthylène très basse densité, copolymère d'éthylène et de propylène ainsi que les copolymères de styrène-butadiène-styrène et de styrène-éthylène-butadiène-styrène. Des charges non conductrices thermiques telles que des silicates sont mises en œuvre dans la fabrication du matériau pour améliorer la rétention du MCP dans le polymère. US5053446 décrit l'obtention d'un composite à base d'une polyoléfine et d'un MCP et de 10 à 50% massique de charges telles que de la silice ou du métaphosphate de calcium et de silicium qui permettent d'améliorer la rétention des charges par le matériau. Aucune charge thermiquement conductrice n'est utilisée, la conductivité thermique du matériau n'est pas mentionnée.

Un troisième procédé comporte dans une première étape la fabrication d'une structure poreuse dans laquelle, dans un second temps, on introduit le MCP. Ainsi US2002/0147242 décrit l'obtention d'une mousse polyuréthane à pores ouverts, dont les pores sont remplies de MCP. US2002/0147242 enseigne que la porosité doit être maximisée en volume afin de permettre un remplissage par une quantité élevée de MCP.

US5637389 décrit l'utilisation conjointe d'une mousse de polymère et de MCP encapsulés, dans la fabrication d'un matériau à caractère isolant thermique qui peut être utilisé dans des semelles de chaussures. Aucune charge thermiquement conductrice n'est utilisée.

US2014/039082 décrit des mousses cellulaires conductrices thermiques comprenant une mousse cellulaire flexible et des particules métalliques. Ces matériaux sont destinés à être utilisés comme matelas. Des PCM peuvent être incorporés dans la mousse, mais il n'est pas indiqué s'ils sont incorporés dans les pores ou dans la matrice polymérique elle-même. Les mousses sont préparées à partir de systèmes précurseurs de polymères bi-composants, à l'aide de tensio-actifs et d'agents de gonflage. Il s'agit donc de polymères non transformables, non thermoplastiques.

US2003/0220432 décrit un matériau thermoplastique conducteur thermique comprenant une matrice de base thermoplastique élastomère, une charge conductrice thermique et un PCM. Ce matériau peut être utilisé comme interface thermique dans l'électronique.

La fiche technique du produit Jumbo de Esponja Extra Fuerte 86 décrit une éponge comprenant des charges métalliques. La matrice est formée à partir de fibres de Nylon formant une maille tridimensionnelle non tissée, liées par une résine époxyde. Ces éponges ne sont pas thermoplastiques ni transformables.

US - 7,316,262 décrit un appareil capable de stocker l'énergie thermique. Il comprend un support d'un matériau à haute conductivité thermique contenant un PCM. Le support peut être une matrice en graphite, en mousse de métal, mais aussi en plastique. La partie expérimentale est mise en œuvre avec une mousse de graphite comme support. Ce document ne divulgue pas un support en matériau composite poreux comprenant une phase polymérique formant liant à base d'au moins un polymère choisi parmi les polymères thermoplastiques, les élastomères et les thermoplastiques élastomères.

Il est connu d'incorporer des charges conductrices thermiques dans une matrice polymérique. Toutefois, l'incorporation de charges conductrices thermiques en quantité importante dans une matrice polymérique présente des difficultés : Plus on introduit de charges dans une matrice polymérique, plus la viscosité du mélange est élevée et plus il est difficile de transformer efficacement le mélange par les méthodes de plasturgie usuelles. Ce problème a été résolu de différentes façons dans l'art antérieur : par l'incorporation de charges en quantités limitées dans le composite final ce qui limite également la conductivité thermique, par l'utilisation de précurseurs de polymères faiblement visqueux qui sont ensuite réticulés, ou encore par la mise en œuvre d'un polymère liant en solution dans un solvant qui est ensuite évaporé. La préparation d'un matériau conducteur thermique par voie solvant présente des problèmes de stockage, de manipulation et de recyclage de quantités importantes de solvants, qui représentent des inconvénients sérieux sur le plan environnemental et sanitaire lorsqu'il s'agit de solvants organiques. La fabrication d'un matériau composite polymérique par voie solvant peut permettre d'obtenir un matériau poreux, mais dont la porosité est difficile à contrôler et d'une épaisseur nécessairement réduite à des films de quelques centaines de micromètres. Un matériau conducteur thermique préparé à partir de précurseurs liquides qui sont ensuite réticulés n'est pas transformable ni recyclable. Par ailleurs, la variété des bases polymériques qui peuvent être employées dans ces procédés est limitée et les durées de procédé sont longues. Ce type de procédé ne permet pas d'obtenir un matériau poreux. Enfin de tels matériaux sont peu conformables et donc d'un intérêt limité dans certaines applications. Des charges fonctionnalisées par des groupements qui permettent leur incorporation en quantités élevées présentent l'inconvénient de nécessiter une étape spécifique de fabrication, ce qui représente un coût supplémentaire pour le matériau.

Les taux de charges conductrices atteignables en voie fondue avec des polymères classiques et des charges minérales ou carbonées non greffées sont, à ce jour, inférieurs à 80 % volumique. De plus, les procédés par voie fondue de l'art antérieur conduisent à un composite dense non poreux.

Dans les applications où l'on cherche à capter rapidement l'énergie calorifique d'une source de chaleur, comme par exemple dans des dispositifs électroniques, il est nécessaire de disposer un matériau doté d'une haute conductivité thermique. En effet, si la chaleur dégagée n'est pas captée ou propagée rapidement à une source de froid, il y a des risques d'accumulation de chaleur pouvant entrainer la décomposition des parties connexes de la source de chaleur, avec pour conséquence éventuelle un départ de feu.

De la même façon, dans les applications au stockage d'énergie thermique, il faut pouvoir transférer l'énergie calorifique au MCP de manière efficace et rapide afin d'augmenter la réactivité du système en termes de stockage et de relargage de cette énergie. En fonction des applications, les matériaux conducteurs thermiques doivent également présenter une conformabilité élevée de façon à épouser les formes des pièces avec lesquelles ils sont en contact. Cette propriété permet d'optimiser les flux de chaleur.

US20020141932 et WO200121551 décrivent des structures poreuses thermiquement conductrices à base de graphite et de poix graphitisée. Des conductivités thermiques d'au moins 50W/m.K sont décrites. Le matériau décrit est obtenu à partir de poix, en passant par des étapes de graphitisation de la poix : hautes températures (>1000°C) et atmosphère non-oxydante. Ce matériau poreux est ensuite rempli de MCP. Du nitrure de bore est mis en œuvre dans la fabrication du matériau dans US20020141932, mais il est employé en vaporisation comme agent de démoulage du matériau graphitisé et non comme charge dans le matériau. La nature graphitique des matériaux enseignés par ces documents leur confère un caractère conducteur électrique. Il s'agit de matériaux rigides non déformables contrairement aux matériaux à support polymérique de l'invention. Des changements de phase répétés lors de l'utilisation sont susceptibles de provoquer des expansions de volume qui elles-mêmes entrainent un risque de dégradation et de perte de cohésion dans ces matériaux de l'art antérieur. Enfin, le caractère graphitique de ces matériaux empêche leur recyclage.

L'objectif de l'invention a été de proposer un matériau conducteur thermique capable de stocker de l'énergie qui remédie aux inconvénients de l'art antérieur.

En particulier, on a cherché à mettre au point un procédé qui conduise à un matériau conducteur thermique poreux dont on puisse remplir la porosité par des MCP. On a également cherché à mettre au point des matériaux qui soient préparés par voie fondue, qui soient éventuellement recyclables et qui incorporent des quantités élevées de charges conductrices thermiques tout en présentant une cohésion satisfaisante. On a cherché à mettre au point un procédé qui puisse être mis en œuvre avec des charges minérales ou des charges carbonées sans qu'une étape de fonctionnalisation de ces charges soit nécessaire. On a également cherché à obtenir un matériau qui soit conformable.

### Résumé de l'invention

Un premier objet de l'invention est un matériau comprenant :
- un support en matériau composite poreux comprenant au moins (A) une phase polymérique formant liant à base d'au moins un polymère choisi parmi les polymères thermoplastiques, les élastomères et les thermoplastiques élastomères, et (B) une ou plusieurs charges choisies parmi les charges conductrices thermiques,
les pores du support en matériau composite poreux étant remplies partiellement ou en totalité par :
- au moins un matériau à changement de phase,
   et le support en matériau composite poreux comprend, en masse par rapport à la masse totale du support :
   - 3 à 20 % d'au moins un polymère choisi parmi les polymères thermoplastiques, les élastomères et les thermoplastiques élastomères,
   - 80 à 97 % d'au moins une charge choisie parmi les charges conductrices thermiques,
   - 0 à 2 % d'un ou plusieurs additifs, ou de résidus de décomposition de la phase sacrificielle.

La demande décrit un procédé de fabrication de ce matériau comprenant :
- La fabrication d'un support en matériau composite poreux comprenant au moins (A) une phase polymérique et (B) une ou plusieurs charges choisies parmi les charges conductrices thermiques,
- Le remplissage partiel ou total de la porosité du support en matériau composite poreux par au moins un matériau à changement de phase.

L'invention a pour objet un procédé de fabrication de ce matériau comprenant :
- La fabrication d'un support en matériau composite poreux comprenant au moins (A) une phase polymérique et (B) une ou plusieurs charges choisies parmi les charges conductrices thermiques,
   la fabrication du support en matériau composite poreux comprenant les étapes suivantes :
   a) Mélangeage à chaud par voie fondue de la phase polymérique (A), des charges (B), et d'une phase polymérique sacrificielle (C), de façon à obtenir un mélange,
   b) Mise en forme du mélange,
   c) Elimination de la phase polymérique sacrificielle,
- Le remplissage partiel ou total de la porosité du support en matériau composite poreux par au moins un matériau à changement de phase.

La demande décrit un procédé de fabrication d'un matériau carboné poreux conducteur thermique, ce procédé comportant
- La fabrication d'un support carboné poreux comprenant au moins (A) une phase polymérique et (B) une ou plusieurs charges choisies parmi les charges conductrices thermiques,
- Le remplissage partiel ou total de la porosité du support carboné poreux par au moins un matériau à changement de phase,
   dans lequel la fabrication du support carboné poreux comprend les étapes suivantes :
   a) Mélangeage à chaud par voie fondue de la phase polymérique (A), des charges (B), et d'une phase polymérique sacrificielle (C), de façon à obtenir un mélange,
   b) Mise en forme du mélange,
   c) Elimination de la phase polymérique sacrificielle,
   d) Pyrolyse ou graphitisation.

L'invention concerne également l'utilisation du matériau défini ci-dessus, ou du matériau obtenu par l'un des procédés définis ci-dessus, dans l'une des applications suivantes :
- dissipateur de chaleur dans un équipement électronique,
- support de stockage de l'énergie.

Selon un mode de réalisation préféré, le matériau à changement de phase forme une phase continue dans la porosité du support en matériau composite poreux.

Selon un mode de réalisation préféré, la phase polymérique formant liant est à base d'au moins un polymère choisi parmi : le polyacrylonitrile, les polyoléfines, les polymères halogénés, les polymères acryliques, les acrylates, les méthacrylates, les vinyl acétates, les polyéthers, les polyesters, les polyamides, les polymères aromatiques, l'acrylonitrile-butadiène hydrogéné, les copolymères d'éthylène et d'un acrylate d'alkyle, le polyisoprène, les caoutchoucs.

Selon un mode de réalisation préféré, les charges sont choisies parmi : le nitrure d'aluminium, le nitrure de bore, le nitrure de magnésium et de silicium, le carbure de silicium, le diamant, le graphite, le graphène, les nanotubes de carbone (CNT), le noir de carbone, les charges métalliques comme l'aluminium, le cuivre ou l'argent, et leurs mélanges.

Selon un mode de réalisation préféré, la porosité représente au moins 40 % en volume par rapport au volume total du support en matériau composite poreux.

Selon un mode de réalisation préféré, le matériau à changement de phase est choisi parmi les chaînes hydrogénocarbonées.

Selon un mode de réalisation préféré, la phase polymérique sacrificielle (C) représente au moins 15 % en masse, de préférence de 20 à 80 % en masse de la masse totale du mélange de l'étape a).

Selon un mode de réalisation préféré, l'étape a) est mise en œuvre dans un mélangeur interne ou dans une extrudeuse.

Selon un mode de réalisation préféré, l'étape c) est mise en œuvre par décomposition par voie thermique de la phase polymérique sacrificielle.

Selon un mode de réalisation préféré, la phase polymérique sacrificielle est à base d'au moins un polymère choisi parmi les polyalcènes carbonates, de préférence parmi les polyéthylènes carbonates et les polypropylènes carbonates.

Selon un mode de réalisation préféré, l'étape b) comporte un façonnage sous forme de film.

Selon un mode de réalisation préféré, le procédé comporte en outre à l'issue de l'étape c) une étape d) de compression.

### Description détaillée

L'invention repose sur un matériau comprenant un support en matériau composite poreux thermiquement conducteur comprenant au moins (A) une phase polymérique à base de polymère transformable par voie fondue et (B) des charges thermiquement conductrices. Cette structure poreuse est remplie de façon partielle ou totale par au moins un MCP afin de générer un réservoir de stockage d'énergie thermique.

Ce matériau de stockage thermique doté d'une haute conductivité thermique, ainsi qu'une haute chaleur latente, a pu être obtenu au moyen d'un procédé mettant en œuvre des méthodes de transformation plastique classiques. Dans une première étape est produit un matériau thermiquement conducteur. Ce matériau présente une bonne cohésion mécanique grâce à l'emploi d'une phase polymère comme liant, et une conductivité thermique élevée grâce à la présence de charges minérales conductrices thermiques. Ce matériau présente une porosité contrôlée en quantité, en dimension des pores et en morphologie grâce à l'emploi d'une phase sacrificielle (C). La porosité de ce matériau est ensuite remplie, de façon totale ou partielle, par un matériau à changement de phase (MCP), qui assure la fonction de stockage thermique.

Ce résultat a été obtenu au moyen d'une méthode permettant d'incorporer, directement en voie fondue et par les méthodes de transformation plastique classiques, de très hauts taux de charges minérales ou carbonées conductrices thermiques dans le matériau final. La composition est choisie au regard du procédé de fabrication employé et de l'application finale du matériau. Le procédé de l'invention permet également d'orienter les charges avec un facteur de forme, en s'appuyant sur les paramètres de mise en œuvre et, le cas échéant, sur une étape additionnelle de recompression. Le procédé de l'invention a permis de produire en voie fondue des matériaux conducteurs thermiques qui contiennent un taux de charges minérales ou carbonées supérieur à 80% en masse sans modification au préalable de la surface des charges ni utilisation d'agent de couplage ou de solvant, ces matériaux étant utilisables en l'état pour un remplissage par un MCP.

Le mélange, la dispersion et la répartition homogène du polymère liant et de la phase sacrificielle et des différentes charges minérales ou carbonées sont assurés par la mise en œuvre du procédé en voie fondue. Une éventuelle pyrolyse ou graphitisation du polymère liant est possible dans un second temps pour optimiser les performances, en fonction de l'application envisagée. Le contrôle de la porosité en termes de taille, de volume et de morphologie est assuré par le contrôle des paramètres de mélange (profil de vis, etc...) au cours de la mise en œuvre du procédé. Dans un second temps, le matériau peut être soumis à une étape de compression qui entraine une réduction du volume poreux. Le contrôle de la porosité est adapté en fonction de l'application envisagée.

Dans la présente description, l'expression « polymère » désigne aussi bien des homopolymères que des copolymères. Elle inclut les mélanges de polymères, les oligomères, les mélanges de monomères, d'oligomères et de polymères.

L'expression « consiste essentiellement en » suivie d'une ou plusieurs caractéristiques, signifie que peuvent être inclus dans le procédé ou le matériau de l'invention, outre les composants ou étapes explicitement énumérés, des composants ou des étapes qui ne modifient pas significativement les propriétés et caractéristiques de l'invention.

### - Le support en matériau composite poreux thermiquement conducteur

Le support en matériau composite poreux thermiquement conducteur comporte une phase polymère formant liant et des charges thermiquement conductrices. Il est obtenu en mettant en œuvre une phase sacrificielle.

### La phase polymérique formant liant :

Le support en matériau composite poreux de l'invention est notamment constitué d'une phase polymérique formant liant et assurant sa cohésion. La phase polymérique peut être de toute nature dès lors qu'elle peut être transformée par voie fondue et qu'elle est compatible avec la phase sacrificielle choisie.

La phase polymérique formant liant présente avantageusement une température de fusion inférieure d'au moins 20°C par rapport à la température de décomposition de la phase sacrificielle de façon à permettre la transformation par voie fondue du mélange. La phase polymérique formant liant est solide à température ambiante (aux environs de 20-25°C) puisqu'elle doit pouvoir être mise en forme et constituera le liant du matériau final.

La compatibilité entre la phase polymérique formant liant et la phase polymérique sacrificielle est évaluée de façon bien connue de l'homme du métier en effectuant le mélange des matériaux par voie fondue et en observant s'il se produit une séparation de phase ou si le mélange est sensiblement homogène. Pour mettre en œuvre le procédé et obtenir un matériau satisfaisant il est nécessaire d'éviter une macroséparation de phase entre le polymère liant et le polymère sacrificiel lors de la mise en œuvre, macroséparation qui se traduirait par la présence d'une phase pure de polymère non dispersée de dimension supérieure à quelques dizaines de µm.

Pour la réalisation de ce mélange, différents paramètres permettent, de façon bien connue, de moduler la compatibilité entre les deux phases. On peut citer par exemple et de façon non limitative : choix de l'équipement, tel que profil de vis ; proportion des phases ; agent compatibilisant. On peut se reporter à un ouvrage général comme : "Mixing and Compounding of Polymers Theory and Practice", 2nd édition, Ica Edition, Manas-Zloczower, qui décrit de façon détaillée les principales connaissances en matière de mélange des polymères.

Le choix des deux phases permet de contrôler la mise en œuvre du procédé, mais aussi les propriétés du support composite poreux final, telles que son intégrité, sa porosité, sa conformabilité.

La nature du matériau qui constitue la phase polymérique formant liant est choisie en fonction des propriétés finales que l'on attend du matériau, comme par exemple sa plasticité, ses propriétés mécaniques.

Selon un mode de réalisation de l'invention, on met en œuvre dans la phase polymérique formant liant des polymères pyrolysables et/ou graphitisables. Après une étape supplémentaire de pyrolyse ou de graphitisation, ces polymères permettent d'obtenir des matériaux carbonés dotés d'une conductivité thermique.

La phase polymérique formant liant comprend des polymères et éventuellement des additifs. De préférence, les polymères représentent au moins 75 % en masse de la phase polymérique formant liant, avantageusement au moins 90%.

Avantageusement, les polymères mis en œuvre dans le procédé de l'invention et entrant dans la composition du matériau final (avant une éventuelle pyrolyse) sont choisis parmi : les thermoplastiques, les élastomères et les thermoplastiques élastomères. On peut citer par exemple : le polyacrylonitrile, les polyoléfines, les polymères halogénés, les polymères acryliques, acrylates, méthacrylates, les vinyl acétates, les polyéthers, les polyesters, les polyamides, les polymères aromatiques ou encore les polymères élastomères comme par exemple l'acrylonitrile-butadiène hydrogéné (HNBR), les copolymères d'éthylène et d'un acrylate d'alkyle, le polyisoprène ou autres caoutchoucs.

La phase polymérique formant liant est à base d'au moins un polymère choisi parmi : les thermoplastiques, les élastomères, les élastomères thermoplastiques, ce qui signifie que les polymères thermoplastiques, les élastomères et les thermoplastiques élastomères représentent au moins 95 % en masse des polymères de la phase polymérique formant liant, avantageusement au moins 98%.

Selon un mode de réalisation préféré de l'invention, la phase polymérique formant liant comporte au moins 50 %, préférentiellement au moins 90%, encore mieux, au moins 95% en masse d'au moins un polymère choisi parmi le polyacrylonitrile, l'acrylonitrile-butadiène hydrogéné et leurs mélanges.

Parmi les additifs susceptibles d'être mis en œuvre dans la phase polymérique formant liant, on peut mentionner les additifs qui sont choisis pour leur fonction dans le matériau final comme par exemple : des agents améliorant la tenue au feu ou à l'oxydation ou encore des agents de réticulation, comme les composés organiques bifonctionnels, les peroxydes organiques ou des composés soufrés (pour la réticulation des caoutchoucs), des co-agents comme le tri-allyl cyanurate. L'utilisation de ces additifs est utile sans être nécessaire à l'invention et dépend directement de l'application visée.

### La phase polymérique sacrificielle :

La phase polymérique sacrificielle est composée de matériaux qui ont la propriété de se décomposer lors de l'application d'une contrainte externe choisie, comme par exemple par élévation de la température ou par dissolution dans un solvant. L'élimination ou l'extraction de la phase sacrificielle doit pouvoir être mise en œuvre sans impacter le reste du matériau. Il est préférable d'utiliser comme matière sacrificielle un composé laissant peu ou pas de résidus lors de la décomposition. Dans le cadre de la présente invention, la présence de petites quantités de matière sacrificielle dans les pores du support composite poreux peut améliorer la mouillabilité de ce support et donc faciliter son remplissage par le MCP.

Avantageusement, la phase polymérique sacrificielle est solide à température ambiante (aux environs de 20-25°C) de façon à permettre la mise en forme de la composition.

De préférence, on choisit une phase sacrificielle qui peut être extraite par décomposition thermique, et on privilégie des polymères ayant une température de dégradation franche connus de la littérature, en s'assurant que la température de dégradation de la phase sacrificielle est inférieure d'au moins 20°C par rapport à la température de dégradation du ou des polymère(s) choisi(s) pour la phase polymérique formant liant. Parmi les polymères susceptibles d'être éliminés par élévation de la température, on peut citer les polyalcènes carbonates, comme par exemple les polyéthylènes carbonates et les polypropylènes carbonates. Généralement, ces matériaux présentent l'avantage de se décomposer avec une expansion volumique modérée ou nulle. Ainsi, le volume de la pièce mise en forme n'est pas ou peu affecté par l'étape de décomposition de la phase sacrificielle. En présence de certaines charges telles que le graphite, la mise en œuvre de polyalcènes carbonates peut néanmoins parfois conduire à une expansion volumique. Pour améliorer la fluidité du matériau polymérique intermédiaire et faciliter la mise en œuvre du procédé, de façon connue de l'homme du métier, on peut utiliser un mélange de polyalcènes carbonates de masses molaires différentes.

Selon un autre mode de réalisation, la phase polymérique sacrificielle peut être extraite par un solvant et est à base d'au moins un polymère sacrificiel extractible par voie liquide, de préférence choisi parmi : les polyéthylène glycols, les polypropylène glycols et leurs mélanges.

La phase polymérique sacrificielle comprend des polymères et éventuellement des additifs. De préférence, les polymères représentent au moins 95 % en masse de la phase polymérique sacrificielle, avantageusement au moins 98%.

Avantageusement, la phase polymérique sacrificielle est à base d'au moins un polymère choisi parmi les polyalcènes carbonates, ce qui signifie que les polyalcènes carbonates représentent au moins 95 % en masse de la phase polymérique sacrificielle, avantageusement au moins 98%.

Selon un mode de réalisation préféré de l'invention les polyéthylènes carbonates et les polypropylènes carbonates représentent au moins 95 % en masse de la phase polymérique sacrificielle, avantageusement au moins 98%.

Parmi les additifs susceptibles d'être mis en œuvre dans la phase polymérique sacrificielle, on peut citer les générateurs photoacides qui agissent comme additifs d'aide à la décomposition des phases sacrificielles. De tels produits sont décrits dans Cupta M., Jayachandran P., Khol P., Photoacid generators for catalytic decomposition of polycarbonate, Journal of applied polymer science, 2007, Vol. 105, p.2655-2662, pour le polypropylène carbonate par exemple. L'utilisation de ces photoacides dans la phase polymérique sacrificielle permet de diminuer les températures de dégradation. Ils sont donc utiles sans être nécessaires à l'invention.

### Les charges:

Selon l'invention, on met en œuvre dans le support en matériau composite poreux de l'invention des charges conductrices thermiques. La charge thermiquement conductrice est avantageusement choisie parmi celles ayant une conductivité thermique supérieure ou égale à 5 W/mK.

La conductivité thermique intrinsèque de charges connues est décrite par exemple dans "Thermal conductivity of Nonmetallic Solids," Y. S. Touloukian, R. W. Powell, C. Y. Ho, and P. G. Klemans, IFI/Plenum: New York-Washington, 1970 ou dans "Thermal Conductivity-Theory, Properties and Applications," T. M. Tritt, Ed., Kluwer Academic/Plenum Publishers: New York, 2004.

De préférence, la charge thermiquement conductrice a une conductivité thermique intrinsèque supérieure ou égale à 10 W/mK, de préférence encore supérieure ou égale à 25 W/mK, avantageusement supérieure ou égale à 50 W/mK.

Des charges thermiquement conductrices qui peuvent être mises en œuvre dans l'invention sont par exemple : AIN (nitrure d'aluminium), BN (nitrure de bore), MgSiN2 (nitrure de magnésium et de silicium), SiC (carbure de silicium), le graphite, le graphène, les nanotubes de carbone (CNT), les nanofibres de carbone, le noir de carbone, le diamant, les charges métalliques comme l'aluminium, le cuivre ou l'argent ou une combinaison de ceux-ci.

Il faut souligner que certaines de ces charges, comme les charges métalliques, le graphite, le graphène, les nanotubes de carbone (CNT), les nanofibres de carbone, le noir de carbone, peuvent également être conductrices électriques. Lorsque l'on souhaite obtenir un matériau électriquement isolant, on évite d'employer de telles charges. Dans ce cas, on utilise de préférence une charge présentant une résistivité supérieure ou égale à 10³ Ohm.cm, comme le nitrure d'aluminium, le nitrure de bore, le nitrure de magnésium et de silicium ou le carbure de silicium.

### Les additifs :

Outre les additifs destinés à modifier les propriétés du support en matériau composite poreux, et ceux destinés à faciliter l'élimination de la phase sacrificielle, il est possible d'ajouter à la composition des additifs spécifiques afin d'améliorer et/ou optimiser le procédé de fabrication des matériaux, comme par exemple des agents compatibilisants. Ces additifs facilitant la mise en œuvre du procédé peuvent être incorporés préalablement dans l'une ou l'autre des phases polymériques, ou avec les charges, ou ils peuvent être incorporés de façon indépendante.

### Le procédé de préparation d'un support en matériau composite poreux :

Le procédé de l'invention repose sur l'utilisation d'une phase polymérique sacrificielle dans un procédé en voie fondue, permettant à la fois une plastification, une meilleure fluidité de la matière pendant la mise en œuvre et une cohésion à l'état fondu mais aussi la création d'une porosité contrôlée. Par exemple, une porosité ouverte pourra être recherchée afin de réduire la densité du matériau tout en assurant une conductivité thermique importante et la capacité d'y intégrer une phase de MCP continue. La porosité peut être contrôlée directement par la quantité de matière sacrificielle introduite ou par une éventuelle compression du matériau après mise en forme et élimination de la phase sacrificielle. Il est à noter que le procédé selon l'invention permet à la fois des temps de procédé courts, typiques des procédés de plasturgie conventionnels, comme l'extrusion, mais aussi l'utilisation d'étapes nécessitant une cohésion à l'état fondu comme l'extrusion calandrage. Il faut aussi souligner que la capacité du mélange à être transformé est maintenue après mise en forme, tant qu'aucune extraction ou pyrolyse n'a été effectuée.

Ce procédé comprend les étapes suivantes :
a) Mélangeage à chaud par voie fondue de la phase polymérique formant liant (A), des charges (B), et de la phase polymérique sacrificielle (C) de façon à obtenir un mélange,
b) Mise en forme du mélange,
c) Elimination de la phase polymérique sacrificielle.

L'étape a) peut être mise en œuvre de façon connue dans tout type d'équipement permettant d'homogénéiser la composition tout en la chauffant. On peut citer notamment un mélangeur interne ou une extrudeuse. Par rapport aux procédés antérieurs, le procédé de l'invention présente de nombreux avantages, et en particulier l'étape de mélangeage est mise en œuvre sans solvant. La phase polymérique formant liant est dispersée de manière homogène dans la phase polymérique sacrificielle continue, ou bien elle forme une phase co-continue avec cette dernière.

Pour faciliter l'obtention d'un mélange homogène, on peut par exemple mettre en œuvre la phase polymérique sacrificielle sous forme de granulés de taille moyenne en nombre supérieure à 1mm.

Le chauffage est contrôlé de façon à porter les phases polymériques à la fusion sans décomposer la phase sacrificielle ou à une température à laquelle la phase sacrificielle se décompose très lentement (sur une durée supérieure à 1h). Avantageusement, le chauffage à l'étape a) est contrôlé pour porter le mélange à une température au moins supérieure de 20°C à la température de transition vitreuse ou de fusion des polymères de la phase polymérique formant liant.

L'étape de mise en forme est adaptée en fonction de la forme finale et des dimensions que l'on souhaite conférer à l'objet. La mise en forme peut consister par exemple en une ou plusieurs étapes choisies parmi : l'extrusion, le soufflage, l'injection, le moulage, le calandrage, le malaxage et leurs combinaisons.

Un avantage du procédé de l'invention réside dans la possibilité, lorsque l'on utilise des charges avec un facteur de forme, d'orienter ces charges. La création d'une porosité contribue en elle-même à l'orientation de ces charges. Par ailleurs, le passage au travers d'une filière d'extrusion dans des conditions de pression choisies permet de conférer une orientation à de telles charges. La compression et/ou le calandrage peuvent également contribuer à l'orientation des charges. Une telle orientation de charges dans le matériau composite poreux se traduit par une asymétrie des propriétés, et permet d'augmenter les propriétés de conductivité thermique dans une direction du matériau.

Le procédé de l'invention permet également d'obtenir des objets de formes variées, autosupportés, et pas uniquement des revêtements attachés à un support.

A l'issue des étapes a) ou b) on obtient une composition polymérique qui est une composition intermédiaire du procédé de l'invention. Elle peut être à l'état fondu ou déjà mise en forme. C'est un précurseur du support composite poreux. Cette composition comprend au moins :
(A) une phase polymère transformable par voie fondue, avantageusement à base de polymères choisis parmi les polymères thermoplastiques, les élastomères et les thermoplastiques élastomères,
(B) une charge choisie parmi les charges conductrices thermiques
(C) une phase polymérique sacrificielle.

La demande décrit une composition dans laquelle les charges (B) représentent au moins 80% en masse par rapport à la somme des masses du polymère (A) et des charges (B).

Avantageusement dans cette composition, la phase polymérique sacrificielle (C) représente au moins 15 % en masse par rapport à la somme des masses de (A), (B) et (C).

La demande décrit une composition polymérique qui comprend, ou mieux consiste essentiellement en, en masse par rapport à la masse totale de la composition :
(A) 1 à 15 % de phase polymère à base de polymères choisis parmi les polymères thermoplastiques, les élastomères et les thermoplastiques élastomères,
(B) 40 à 70% de charge(s) choisie(s) parmi les charges conductrices thermiques,
(C) 20 à 80% de phase polymérique sacrificielle.

Cette composition polymérique peut être préparée et mise en forme directement sous la forme souhaitée pour l'utilisation (film, boîtier, etc...).

De façon alternative, on prévoit un mode de réalisation où la composition est préparée (mélange homogène en voie fondue des composants (A), (B) et (C)) et mise sous forme de granulés par exemple. Cette composition est ensuite facilement réintroduite dans le procédé de l'invention à l'étape a). Ce mode de réalisation permet de fournir une composition prête à être mise en œuvre qui ne nécessite pas de dosage des composants et évite les erreurs de manipulation liées à l'introduction des composants dans le mélangeur.

La phase polymérique sacrificielle est éliminée après mise en forme de la composition polymérique composite sensiblement sans laisser de résidus. Cette étape peut être réalisée de façon connue par élévation de température, par exemple dans une étuve. Elle peut également être réalisée par d'autres moyens, comme par exemple par dissolution de la phase sacrificielle à l'aide d'un solvant.

Outre les étapes décrites ci-dessus, le procédé de l'invention peut comporter d'autres étapes. En particulier, selon un mode de réalisation de l'invention, il comporte une ou plusieurs étapes de mise en forme à l'issue de l'étape c), et notamment un découpage du matériau aux dimensions souhaitées, une compression qui permet de réduire la porosité. La compression peut par exemple être réalisée au moyen d'une presse à plateaux ou par calandrage. Une éventuelle réticulation de la phase formant liant est possible pour optimiser les propriétés mécaniques et la cohésion de la composition si une transformation ultérieure n'est pas envisagée.

La demande décrit un support en matériau composite poreux qui comprend, ou mieux consiste essentiellement en, en masse par rapport à la masse totale du support :
- 3 à 20 % d'au moins un polymère choisi parmi les polymères thermoplastiques, les élastomères et les thermoplastiques élastomères,
- 80 à 97 % d'au moins une charge choisie parmi les charges conductrices thermiques,
- 0 à 2 % d'un ou plusieurs additifs, ou de résidus de décomposition de la phase sacrificielle.

Encore plus préférentiellement, le support en matériau composite poreux comprend, ou mieux consiste essentiellement en, en masse par rapport à la masse totale du support :
- 4 à 10 % d'au moins un polymère choisi parmi les polymères thermoplastiques, les élastomères et les thermoplastiques élastomères,
- 90 à 96 % d'au moins une charge choisie parmi les charges conductrices thermiques,
- 0 à 1% d'un ou plusieurs additifs, ou de résidus de décomposition de la phase sacrificielle.

La demande décrit un support en matériau composite poreux qui comprend, ou mieux consiste essentiellement en, en masse par rapport à la masse totale du support :
- 3 à 20 % d'au moins un polymère choisi parmi le polyacrylonitrile, les polyoléfines, les polymères halogénés, les polymères acryliques, les acrylates, les méthacrylates, les vinyl acétates, les polyéthers, les polyesters, les polyamides, les polymères aromatiques, l'acrylonitrile-butadiène hydrogéné, les copolymères d'éthylène et d'un acrylate d'alkyle, le polyisoprène, les caoutchoucs,
- 80 à 97 % d'au moins une charge choisie parmi : le nitrure d'aluminium, le nitrure de bore, le nitrure de magnésium et de silicium, le carbure de silicium, le diamant, et leurs mélanges,
- 0 à 2 % d'un ou plusieurs additifs, ou de résidus de décomposition de la phase sacrificielle.

Selon un mode de réalisation préféré de l'invention, le support en matériau composite poreux comprend, ou mieux consiste essentiellement en, en masse par rapport à la masse totale du support :
- 4 à 10 % d'au moins un polymère choisi parmi le polyacrylonitrile, les polyoléfines, les polymères halogénés, les polymères acryliques, les acrylates, les méthacrylates, les vinyl acétates, les polyéthers, les polyesters, les polyamides, les polymères aromatiques, l'acrylonitrile-butadiène hydrogéné, les copolymères d'éthylène et d'un acrylate d'alkyle, le polyisoprène, les caoutchoucs,
- 90 à 96 % d'au moins une charge choisie parmi : le nitrure d'aluminium, le nitrure de bore, le nitrure de magnésium et de silicium, le carbure de silicium, le diamant, et leurs mélanges,
- 0 à 1% d'un ou plusieurs additifs, ou de résidus de décomposition de la phase sacrificielle.

Avantageusement, ce support est obtenu à l'issue du procédé décrit ci-dessus.

Le support en matériau composite poreux de l'invention présente des propriétés de conductivité thermique élevées, en raison de la présence des charges conductrices thermiques en proportion importante. Le support en matériau composite poreux de l'invention présente une porosité et une densité qui peuvent être contrôlées. En effet, plusieurs paramètres du procédé permettent de modifier ces propriétés du matériau : les proportions du mélange initial de (A), (B), (C) et éventuellement le mode de mise en forme, une éventuelle étape de compression. La porosité peut ainsi être contrôlée en termes de taille, de morphologie et de quantité des pores. En fonction des applications et des contraintes liées à l'utilisation, on choisit de favoriser une densité plus ou moins élevée du support.

Par support en matériau composite poreux on entend un matériau dont au moins 1% en volume, avantageusement au moins 10% en volume, est constitué de pores.

Avantageusement, le support de l'invention présente une porosité continue.

Selon un mode de réalisation de l'invention, la porosité représente de 10 à 70% en volume par rapport au volume total du matériau, préférentiellement de 20 à 60%.

De préférence, on privilégie une porosité fine qui permet de retenir le MCP dans les pores du support, même lorsqu'il est à l'état liquide. En outre, les MCP étant non conducteurs thermiques, leur présence dans le matériau réduit la conductivité thermique de celui-ci. Le choix d'une porosité fine permet de réduire l'influence du MCP sur la conductivité thermique du matériau rempli de MCP.

Le matériau est mis en forme en fonction de l'utilisation envisagée, notamment sous forme de feuilles, de films, mais aussi de gaines, de câbles, de revêtements, de granulés, de boîtiers. Par exemple, le procédé de l'invention donne accès à des supports composites poreux sous forme de sphères, qui, une fois la porosité remplie par des MCP, peuvent être utilisées pour le stockage d'énergie.

Avantageusement, le support en matériau composite poreux est autosupporté.

Par rapport aux supports obtenus par voie solvant, qui peuvent également être poreux, le matériau de l'invention présente l'avantage de pouvoir présenter des formes variées, d'épaisseur importante. En effet, par voie solvant, on a accès à des matériaux sous forme de films de quelques centaines de microns d'épaisseur maximale, tandis que les matériaux de l'invention peuvent être de toutes formes et de toutes dimensions. Dans l'hypothèse où le matériau de l'invention est sous forme de film, avantageusement, il est d'une épaisseur supérieure ou égale à 250 µm, préférentiellement supérieure ou égale à 500 µm, avantageusement encore supérieure ou égale à 1 mm, encore mieux, supérieure ou égale à 2,5 mm.

Le matériau de l'invention se caractérise avantageusement en ce qu'il présente dans toutes les directions de l'espace une épaisseur supérieure ou égale à 250 µm, préférentiellement supérieure ou égale à 500 µm, avantageusement encore supérieure ou égale à 1 mm.

Les supports en matériau composites thermiques de l'invention présentent une combinaison de propriétés intéressante : ils sont à la fois poreux et présentent une conductivité thermique élevée.

### - Le matériau à changement de phase

Les matériaux à changement de phase possèdent la capacité de modifier leur état physique dans un certain intervalle de température. Lorsque par chauffage la température de fusion est atteinte, il se produit le changement de phase de l'état solide à l'état liquide. Au cours de ce processus de fusion, le matériau à changement de phase absorbe et stocke une grande quantité de chaleur latente. La température du matériau à changement de phase reste pratiquement constante pendant tout le processus. Dans un procédé de refroidissement d'un matériau à changement de phase, dans une certaine plage de température, la chaleur stockée est libérée dans l'environnement, et un changement de phase inverse de l'état liquide à l'état solide se produit. Au cours de ce processus de cristallisation, la température du matériau à changement de phase reste également constante. L'intérêt des matériaux à changement de phase comme source de stockage de chaleur se fonde sur le transfert de chaleur pendant le processus de fusion et le processus de cristallisation.

De nombreux matériaux à changement de phase sont connus, ils diffèrent par leurs plages de changement de température et leurs capacités de stockage d'énergie. Ces matériaux peuvent être utilisés individuellement ou en mélange de façon à moduler leurs plages de température de changement de phase.

Par exemple on peut citer : les chaînes hydrogénocarbonées comme l'henéicosane, l'eicosane, le nonadécane, l'octadécane, l'heptadécane, l'hexadécane.

On peut également mentionner : les sels hydratés comme le chlorure de calcium hexahydrate, le nitrate de lithium trihydrate, le sulfate de sodium décahydrate.

On peut également mentionner des solvants liquides à température ambiante, tels que l'eau, l'éthanol, l'acétone.

De préférence on met en œuvre un MCP avec une transition de phase liquide / solide (L/S) plutôt que liquide / gaz (L/G) : d'une part la transition L/S est réversible et d'autre part elle permet de mieux contrôler une éventuelle expansion du matériau.

Préférentiellement, on utilise un MCP qui présente une température de transition de phase inférieure d'au moins 20°C à la température de dégradation de la phase polymérique formant liant.

Le matériau à changement de phase est introduit dans le support en matériau composite poreux par imprégnation, par exemple le support composite poreux est immergé dans le MCP à l'état liquide puis retiré et refroidi, ce qui permet d'obtenir un remplissage complet ou presque complet de la porosité du support. De façon connue de l'homme du métier, le matériau de l'invention est caractérisé pour ses propriétés de stockage d'énergie par calorimétrie différentielle à balayage ou DSC (pour Differential Scan Calorimetry).

Avantageusement, le MCP remplit au moins 50%, préférentiellement au moins 70%, encore mieux au moins 85% en volume par rapport au volume total de la porosité du support en matériau composite poreux.

Un avantage du matériau de l'invention par rapport aux matériaux de l'art antérieur, notamment les matériaux réticulés, est qu'il est transformable et peut être recyclé. On peut par exemple éliminer la phase MCP du matériau pour récupérer le support en matériau composite poreux. On peut ensuite introduire dans l'étape a) du procédé décrit ci-dessus le support en matériau composite poreux récupéré à base de polymère et de charges, en lui ajoutant une nouvelle phase sacrificielle, éventuellement d'autres polymères et charges additionnels, et procéder ainsi à un nouveau cycle de transformation.

Le matériau de l'invention peut être utilisé dans de nombreuses applications telles que : dissipateur de chaleur dans un équipement électronique (heat sink), support de stockage de l'énergie produite par des sources d'énergie renouvelables intermittentes telles que des batteries solaires ou des éoliennes.

### - Matériau carboné poreux conducteur thermique

Selon une variante, l'invention concerne un procédé de fabrication d'un matériau carboné poreux conducteur thermique, ce procédé comportant
- La fabrication d'un support carboné poreux comprenant au moins (A) une phase polymérique et (B) une ou plusieurs charges choisies parmi les charges conductrices thermiques,
- Le remplissage partiel ou total de la porosité du support carboné poreux par au moins un matériau à changement de phase,
   dans lequel la fabrication du support carboné poreux comprend les étapes suivantes :
   a) Mélangeage à chaud par voie fondue de la phase polymérique (A), des charges (B), et d'une phase polymérique sacrificielle (C), de façon à obtenir un mélange,
   b) Mise en forme du mélange,
   c) Elimination de la phase polymérique sacrificielle,
   d) Pyrolyse ou graphitisation.

Avantageusement les mêmes caractéristiques que celles décrites ci-dessus pour les étapes a), b) et c) ainsi que pour les proportions des composants sont mises en œuvre. De façon connue, le traitement de pyrolyse est réalisé à une température supérieure ou égale à 500°C, le traitement de graphitisation à une température supérieure ou égale à 1000°C. Pour cela, le choix de la phase polymérique formant liant doit avoir été adapté pour permettre cette étape. On obtient ainsi un matériau carboné composite comportant une quantité élevée de charges conductrices thermiques et doté d'une porosité et d'une densité contrôlées.

Un tel matériau peut être utilisé comme matériau de stockage d'énergie dans les applications suivantes : encapsulation de composants électroniques, boitiers de batteries, armoires électriques, serveurs.

### Partie expérimentale :

### I- Matériaux et méthodes :

### 1.1 Matériaux :

### Polymère formant liant :

PL 1 : polyacrylonitrile commercialisé par la société Ineos sous la référence Barex 210®
PL2 : élastomère HNBR (acrylonitrile-butadiène hydrogéné) commercialisé par la société Zeon Chemicals sous la référence Zetpol 2010L ®

### Polymère sacrificiel :

PS 1 : polypropylène carbonate commercialisé par la société Novomer sous la référence Polyol 211-10 ®
PS 2 : polypropylène carbonate commercialisé par la société Empower Materials sous la référence QPAC40 ®

### Charge conductrice thermique :

C1 : Graphite commercialisé par la société Timcal sous la référence C-therm 001 ©
C2 : Nitrure d'aluminium

### Matériau à changement de phase :

MCP1 : Eicosane
Extrudeuse : Coperion ZSK18
Mélangeur interne : Scamex de 300 ml

### I.2. Méthodes de test et de caractérisation :

### Conductivité thermique :

Les matériaux ont été caractérisés à la température ambiante et dans le plan par la méthode du hotdisk TPS plaque mince en suivant la norme NI ISO22007-2 : 2008-12 plastique.

### Densité :

Pour évaluer la densité, on a mesuré la masse du matériau sur une balance de précision et le volume au pied à coulisse, le tout à température ambiante.

Calorimétrie différentielle à balayage (DSC) :
Les enthalpies ont été mesurées sur un appareil de marque Mettler entre -20°C et 100°C à une vitesse de montée de 5°C/minute.

### II. Compositions polymériques et matériaux composites :

Dans les tableaux de compositions, les colonnes « Avant extraction » décrivent les proportions de la composition avant l'étape c) d'élimination de la phase sacrificielle, les colonnes « Après extraction » décrivent le matériau obtenu après l'étape c).

### II.1 Exemple 1

### II.1.A Préparation du support composite poreux :

### Formulation :

Un mélange ayant la composition suivante a été préparé :

**Tableau 1.1**

| | Avant extraction | | Après extraction | |
|---|---|---|---|---|
| Composition | %masse | %volume | %masse | %volume |
| PL1 | 13.2 | 17.4 | 19.9 | 29.1 |
| PS1 | 13.8 | 16.5 | 0 | 0 |
| PS2 | 19.8 | 23.8 | 0 | 0 |
| C1 | 53.2 | 42.3 | 80.1 | 70.9 |

### Méthode de préparation :

### - Etape a : Préparation de la composition et extrusion d'un film de matériau composite

La composition a été préparée en utilisant une extrudeuse bi-vis à 175°C. Toutes les matières premières ont été directement injectées dans l'extrudeuse grâce aux doseurs gravimétriques pour les poudres et les granulés, et par une aiguille d'injection pour les liquides. Les débits massiques de chaque composant ont été réglés de manière à obtenir la composition décrite ci-dessus.

### - Etape b : Mise en forme

L'utilisation d'une pompe à engrenages à la suite de l'extrudeuse bi-vis a permis d'extruder des films de 2 mm d'épaisseur en continu. Le film a été découpé sous forme d'échantillons de dimension 5 cm x 5 cm.

### - Etape c : Elimination de la phase sacrificielle

L'échantillon de film précédemment obtenu a été soumis à une étape de décomposition de la phase sacrificielle en étuve sous air à 230°C pendant 20 mn. La mesure de la différence de masse avant et après le traitement thermique permet de suivre et de contrôler l'élimination du polypropylène carbonate. 100% du polypropylène carbonate initialement incorporé dans le mélange est décomposé et éliminé. On obtient un matériau poreux constitué de polymère formant liant PL1 et de charge C1 dans les proportions du tableau 1.1, et dont la porosité représente environ 40% en volume par rapport au volume total du matériau.

### Propriétés :

La conductivité thermique du matériau résultant est de 12.5W/m.°K.

### II.1.B Remplissage du support composite poreux par un MCP :

### Formulation :

Le support composite poreux obtenu a été plongé dans de l'eicosane liquide afin que celui-ci remplisse la porosité. Le matériau a ensuite été retiré de la solution et refroidi. Des mesures de masses ont été effectuées avant et après le contact avec l'eicosane. Il en résulte, après calcul lié à la densité, que 100% de la porosité initiale a été rempli par l'eicosane donnant une nouvelle composition exposée dans le tableau 1.2 :

**Tableau 1.2**

| Composition | %masse | %vol |
|---|---|---|
| PL1 | 15.0 | 17.2 |
| C1 | 60.3 | 41.7 |
| MCP 1 | 24.7 | 41.1 |

### Propriétés :

Le matériau du tableau 1.2 a ensuite été caractérisé par DSC à 1 et 5°C/min en montant en température (fusion) et en descendant en température (cristallisation) entre 0 et 100°C afin de déterminer l'enthalpie stockée et la réversibilité. On obtient une enthalpie de fusion de 80J/g à 5°C/min. Celle-ci s'étale sur une plage de 10°C avec un début de fusion à 36°C et un pic à 41°C.

### II.1 Exemple 2

### II.2.A Préparation du support composite poreux :

### Formulation :

Un mélange ayant la composition suivante a été préparé :

**Tableau 2.1**

| | Avant extraction | | Après extraction | |
|---|---|---|---|---|
| Composition | % masse | % volume | % masse | % volume |
| PL2 | 3.7 | 5.9 | 6.1 | 11.3 |
| PS1 | 25.1 | 30.7 | 0 | 0 |
| PS2 | 13.5 | 16.6 | 0 | 0 |
| C1 | 57.7 | 46.8 | 93.9 | 88.7 |

### Méthode de préparation :

### - Etape a : Préparation de la composition et formation d'un film de matériau composite

La composition a été préparée en utilisant un mélangeur interne à 80°C. Le polymère formant liant PL2 et le polypropylène sacrificiel PS2 ont été introduits et mélangés en premier afin d'obtenir un mélange fondu plastifié. Ensuite les charges minérales C1 ont été ajoutées progressivement avec ajout régulier du polymère sacrificiel PS1 (un préchauffage, à environ 60°C, de la matière peut être nécessaire afin d'en diminuer la viscosité et faciliter l'ajout) jusqu'à obtention d'un mélange homogène.

### - Etape b : Mise en forme

Le mélange précédemment obtenu a ensuite été calandré sous forme d'une feuille d'épaisseur 0,5 cm. Le film obtenu a été découpé sous forme d'échantillons de dimension 5 cm x 5 cm.

### - Etape c : Elimination de la phase sacrificielle

L'échantillon de film précédemment obtenu a été soumis à une étape de décomposition de la phase sacrificielle en étuve sous air à 230°C pendant 20 mn. La mesure de la différence de masse avant et après le traitement thermique permet de suivre et de contrôler l'élimination du polypropylène carbonate. 100% du polypropylène carbonate initialement incorporé dans le mélange est décomposé et éliminé. On observe une expansion volumique du matériau au cours de cette étape. On obtient un matériau poreux constitué de polymère formant liant PL2 et de charge C1 dans les proportions du tableau 2.1.

### - Etape d : Compression

Le mélange est comprimé sous presse à 80°C et 50 bars jusqu'à une épaisseur de film de 0,5 cm de façon à retrouver l'épaisseur originelle. En effet, lors de la décomposition on observe un léger gonflement du mélange. Le matériau après compression présente une densité de 0.844 g/cm³ au lieu de 1.80 g/cm³ théorique (la densité théorique est calculée à partir de la formulation et de la densité de chaque élément). On déduit de la mesure de la densité que le matériau présente une porosité de 53% en volume par rapport au volume total du matériau.

### Propriétés :

A l'issue de l'étape d, on a mesuré la conductivité thermique du matériau dans le sens radial et dans le sens axial. Les conductivités thermiques obtenues sont rapportées dans le tableau 2.2.

**Tableau 2.2**

| Sens | Conductivité thermique (W/m.K) |
|---|---|
| Radial | 16.0 |
| Axial | 1.49 |

On constate que le matériau obtenu cumule plusieurs propriétés : une haute conductivité thermique, une orientation des charges ainsi qu'une faible densité.

### II.2.B Remplissage du support composite poreux par un MCP :

### Formulation :

Le matériau a été plongé dans de l'eicosane liquide afin que celui-ci remplisse la porosité. Le matériau a ensuite été retiré de la solution et refroidi. Des mesures de masses ont été effectuées avant et après le contact avec l'eicosane. Il en résulte, après calcul lié à la densité, qu'environ 90% de la porosité initiale a été rempli par l'eicosane donnant une nouvelle composition présentée dans le tableau 2.3 :

**Tableau 2.3**

| Composition | %masse | %vol |
|---|---|---|
| PL2 | 8.2 | 6 |
| C1 | 63.9 | 47.1 |
| MCP 1 | 27.9 | 46.9 |

### Propriétés :

Le matériau du tableau 2.3 a ensuite été caractérisé par DSC à 1 et 5°C/min en montant en température (fusion) et en descendant en température (cristallisation) entre 0 et 100°C afin de déterminer l'enthalpie stockée et la réversibilité. On obtient une enthalpie de fusion de 85J/g à 5°C/min. Celle-ci s'étale sur une plage de 10°C avec un début de fusion à 36°C et un pic à 39°C.

### II.3 Exemple 3

### II.3.A Préparation du support composite poreux :

### Formulation :

Un mélange ayant la composition suivante (colonne « Avant extraction ») a été préparé :

**Tableau 3.1**

| | Avant extraction | | Après extraction | |
|---|---|---|---|---|
| Composition | %masse | %vol | %masse | %vol |
| PL2 | 4.2 | 9.0 | 5.0 | 15.0 |
| PS1 | 7.7 | 20.0 | 0 | 0 |
| PS2 | 7.6 | 20.0 | 0 | 0 |
| C2 | 80.5 | 51.0 | 95.0 | 85.0 |

### Méthode de préparation :

### - Etape a : Préparation de la composition et formation d'un film de matériau composite

On a procédé comme à l'étape a de l'exemple 2.

### - Etape b : Mise en forme

Le mélange obtenu a ensuite été calandré sous forme d'une feuille d'épaisseur 1cm.

### - Etape c : Elimination de la phase sacrificielle

On a procédé comme à l'étape c de l'exemple 2. Aucune expansion volumique du matériau au cours de cette étape n'est à noter. On obtient un matériau poreux constitué de polymère formant liant PL2 et de charge C2 dans les proportions du tableau 3.1.

### Propriétés :

Lors du traitement thermique on a mesuré par différence de masse le départ du polypropylène carbonate. 100% du polypropylène carbonate initialement incorporé dans le mélange est décomposé.

### II.3.B Remplissage du support composite poreux par un MCP :

### Formulation :

Le matériau a été plongé dans de l'eicosane liquide afin que celui-ci remplisse la porosité. Le matériau a ensuite été retiré de la solution et refroidi. Des mesures de masses ont été effectuées avant et après le contact avec l'eicosane. Il en résulte, après calcul lié à la densité, qu'environ 90% de la porosité initiale a été rempli par l'eicosane donnant une nouvelle composition présentée dans le tableau 3.3 :

**Tableau 3.3**

| Composition | %masse | %vol |
|---|---|---|
| PL2 | 4.2 | 9.1 |
| C2 | 80.7 | 51.3 |
| MCP 1 | 15.1 | 39.6 |

### Propriétés :

Le matériau du tableau 3.3 a ensuite été caractérisé par DSC à 1 et 5°C/min en montant en température (fusion) et en descendant en température (cristallisation) entre 0 et 100°C afin de déterminer l'enthalpie stockée et la réversibilité. On obtient une enthalpie de fusion de 45J/g à 5°C/min. Celle-ci s'étale sur une plage de 10°C avec un début de fusion à 39°C et un pic à 41°C.

## Revendications

1. Matériau comprenant :
- un support en matériau composite poreux comprenant au moins (A) une phase polymérique formant liant à base d'au moins un polymère choisi parmi les polymères thermoplastiques, les élastomères et les thermoplastiques élastomères, et (B) une ou plusieurs charges choisies parmi les charges conductrices thermiques,
les pores du support en matériau composite poreux étant remplies partiellement ou en totalité par :
- au moins un matériau à changement de phase,
et le support en matériau composite poreux comprend, en masse par rapport à la masse totale du support :
• 3 à 20 % d'au moins un polymère choisi parmi les polymères thermoplastiques, les élastomères et les thermoplastiques élastomères,
• 80 à 97 % d'au moins une charge choisie parmi les charges conductrices thermiques,
• 0 à 2 % d'un ou plusieurs additifs, ou de résidus de décomposition de la phase sacrificielle.

2. Matériau selon la revendication 1, dans lequel le support en matériau composite poreux comprend, en masse par rapport à la masse totale du support :
• 4 à 10 % d'au moins un polymère choisi parmi les polymères thermoplastiques, les élastomères et les thermoplastiques élastomères,
• 90 à 96 % d'au moins une charge choisie parmi les charges conductrices thermiques,
• 0 à 1% d'un ou plusieurs additifs, ou de résidus de décomposition de la phase sacrificielle.

3. Matériau selon la revendication 1 ou selon la revendication 2, dans lequel le matériau à changement de phase forme une phase continue dans la porosité du support en matériau composite poreux.

4. Matériau selon l'une quelconque des revendications précédentes, dans lequel la phase polymérique formant liant est à base d'au moins un polymère choisi parmi : le polyacrylonitrile, les polyoléfines, les polymères halogénés, les polymères acryliques, les acrylates, les méthacrylates, les vinyl acétates, les polyéthers, les polyesters, les polyamides, les polymères aromatiques, l'acrylonitrile-butadiène hydrogéné, les copolymères d'éthylène et d'un acrylate d'alkyle, le polyisoprène, les caoutchoucs.

5. Matériau selon l'une quelconque des revendications précédentes, dans lequel les charges sont choisies parmi : le nitrure d'aluminium, le nitrure de bore, le nitrure de magnésium et de silicium, le carbure de silicium, le diamant, le graphite, le graphène, les nanotubes de carbone (CNT), le noir de carbone, les charges métalliques comme l'aluminium, le cuivre ou l'argent, et leurs mélanges.

6. Matériau selon l'une quelconque des revendications précédentes, dans lequel la porosité représente au moins 40 % en volume par rapport au volume total du support en matériau composite poreux.

7. Matériau selon l'une quelconque des revendications précédentes, dans lequel le matériau à changement de phase est choisi parmi les chaînes hydrogénocarbonées.

8. Procédé de fabrication d'un matériau selon l'une quelconque des revendications 1 à 7 comprenant :
- La fabrication d'un support en matériau composite poreux comprenant au moins (A) une phase polymérique et (B) une ou plusieurs charges choisies parmi les charges conductrices thermiques,
la fabrication du support en matériau composite poreux comprenant les étapes suivantes :
a) Mélangeage à chaud par voie fondue de la phase polymérique (A), des charges (B), et d'une phase polymérique sacrificielle (C), de façon à obtenir un mélange,
b) Mise en forme du mélange,
c) Elimination de la phase polymérique sacrificielle,
- Le remplissage partiel ou total de la porosité du support en matériau composite poreux par au moins un matériau à changement de phase.

9. Procédé selon la revendication 8, dans lequel la phase polymérique sacrificielle (C) représente au moins 15 % en masse, de préférence de 20 à 80 % en masse de la masse totale du mélange de l'étape a).

10. Procédé selon l'une quelconque des revendications 8 et 9 dans lequel l'étape a) est mise en œuvre dans un mélangeur interne ou dans une extrudeuse.

11. Procédé selon l'une quelconque des revendications 8 à 10 dans lequel l'étape c) est mise en œuvre par décomposition par voie thermique de la phase polymérique sacrificielle.

12. Procédé selon la revendication 11 dans lequel la phase polymérique sacrificielle est à base d'au moins un polymère choisi parmi les polyalcènes carbonates, de préférence parmi les polyéthylènes carbonates et les polypropylènes carbonates.

13. Procédé selon l'une quelconque des revendications 8 à 12 dans lequel l'étape b) comporte un façonnage sous forme de film.

14. Procédé selon l'une quelconque des revendications 8 à 13 qui comporte en outre à l'issue de l'étape c) une étape d) de compression.

15. Utilisation du matériau selon l'une quelconque des revendications 1 à 7, ou du matériau obtenu par le procédé selon l'une quelconque des revendications 8 à 14 dans l'une des applications suivantes :
- dissipateur de chaleur dans un équipement électronique,
- support de stockage de l'énergie.

## Patentansprüche

1. Material, umfassend:
- einen Träger aus porösem Verbundmaterial, umfassend mindestens (A) eine Polymerphase, die ein Bindemittel bildet, auf der Basis mindestens eines Polymers, ausgewählt aus thermoplastischen Polymeren, Elastomeren und thermoplastischen Elastomeren, und (B) einen oder mehrere Füllstoffe, ausgewählt aus wärmeleitenden Füllstoffen,
wobei die Poren des Trägers aus porösem Verbundmaterial teilweise oder vollständig gefüllt sind mit:
- mindestens einem Phasenwechselmaterial,
und der Träger aus porösem Verbundmaterial, bezogen auf das Gesamtgewicht des Trägers, Folgendes umfasst:
• 3 bis 20 Gew.-% mindestens eines Polymers, ausgewählt aus thermoplastischen Polymeren, Elastomeren und thermoplastischen Elastomeren,
• 80 bis 97 Gew.-% mindestens eines Füllstoffs, ausgewählt aus wärmeleitenden Füllstoffen,
• 0 bis 2 Gew.-% eines oder mehrerer Additive oder Zersetzungsrückstände der Opferphase.

2. Material nach Anspruch 1, wobei der Träger aus porösem Verbundmaterial, bezogen auf das Gesamtgewicht des Trägers, Folgendes umfasst:
• 4 bis 10 Gew.-% mindestens eines Polymers, ausgewählt aus thermoplastischen Polymeren, Elastomeren und thermoplastischen Elastomeren,
• 90 bis 96 Gew.-% mindestens eines Füllstoffs, ausgewählt aus wärmeleitenden Füllstoffen,
• 0 bis 1 Gew.-% eines oder mehrerer Additive oder Zersetzungsrückstände der Opferphase.

3. Material nach Anspruch 1 oder Anspruch 2, wobei das Phasenwechselmaterial eine kontinuierliche Phase im Porenvolumen des Trägers aus porösem Verbundmaterial bildet.

4. Material nach einem der vorhergehenden Ansprüche, wobei die ein Bindemittel bildende Polymerphase auf mindestens einem Polymer basiert, ausgewählt aus: Polyacrylnitril, Polyolefinen, halogenierten Polymeren, Acrylpolymeren, Acrylaten, Methacrylaten, Vinylacetaten, Polyethern, Polyestern, Polyamiden, aromatischen Polymeren, hydriertem AcrylnitrilButadien, Copolymeren aus Ethylen und einem Alkylacrylat, Polyisopren und Kautschuken.

5. Material nach einem der vorhergehenden Ansprüche, wobei die Füllstoffe ausgewählt sind aus: Aluminiumnitrid, Bornitrid, Magnesium- und Siliziumnitrid, Siliziumcarbid, Diamant, Graphit, Graphen, Kohlenstoffnanoröhren (CNT), Ruß, metallischen Füllstoffen, wie Aluminium, Kupfer oder Silber, und deren Gemischen.

6. Material nach einem der vorhergehenden Ansprüche, wobei das Porenvolumen mindestens 40 Vol.-%, bezogen auf das Gesamtvolumen des Trägers aus porösem Verbundmaterial, ausmacht.

7. Material nach einem der vorhergehenden Ansprüche, wobei das Phasenwechselmaterial aus Kohlenwasserstoffketten ausgewählt ist.

8. Verfahren zur Herstellung eines Materials nach einem der Ansprüche 1 bis 7, umfassend:
- das Herstellen eines Trägers aus porösem Verbundmaterial, umfassend mindestens (A) eine Polymerphase und (B) einen oder mehrere Füllstoffe, ausgewählt aus wärmeleitenden Füllstoffen,
wobei die Herstellung des Trägers aus porösem Verbundmaterial die folgenden Schritte umfasst:
a) Heißschmelzmischen der Polymerphase (A), der Füllstoffe (B) und einer Polymer-Opferphase (C) unter Herstellung eines Gemischs,
b) Formen des Gemischs,
c) Entfernen der Polymer-Opferphase,
- teilweises oder vollständiges Füllen des Porenvolumens des Trägers aus porösem Verbundmaterial mit mindestens einem Phasenwechselmaterial.

9. Verfahren nach Anspruch 8, wobei die Polymer-Opferphase (C) mindestens 15 Gew.-%, vorzugsweise 20 bis 80 Gew.-%, bezogen auf das Gesamtgewicht des Gemischs von Schritt a), ausmacht.

10. Verfahren nach einem der Ansprüche 8 und 9, wobei Schritt a) in einem Innenmischer oder einem Extruder durchgeführt wird.

11. Verfahren nach einem der Ansprüche 8 bis 10, wobei Schritt c) durch thermische Zersetzung der Polymer-Opferphase durchgeführt wird.

12. Verfahren nach Anspruch 11, wobei die Polymer-Opferphase auf mindestens einem aus Polyalkencarbonaten, vorzugsweise aus Polyethylencarbonaten und Polypropylencarbonaten, ausgewählten Polymer basiert.

13. Verfahren nach einem der Ansprüche 8 bis 12, wobei Schritt b) die Verarbeitung in Form einer Folie beinhaltet.

14. Verfahren nach einem der Ansprüche 8 bis 13, das ferner nach Schritt c) noch einen Komprimierungsschritt d) beinhaltet.

15. Verwendung des Materials nach einem der Ansprüche 1 bis 7 oder des durch das Verfahren nach einem der Ansprüche 8 bis 14 erhaltenen Materials bei einer der folgenden Anwendungen:
- Wärmesenke in einem elektronischen Gerät,
- Energiespeichermedium.

## Claims

1. Material comprising:
- a support made of porous composite material comprising at least (A) one polymer phase forming a binder based on at least one polymer chosen from thermoplastic polymers, elastomers and thermoplastic elastomers, and (B) one or more fillers chosen from thermally conductive fillers,
the pores of the support made of porous composite material being partially or totally filled with:
- at least one phase-change material,
and the support made of porous composite material comprises, by weight relative to the total weight of the support:
• 3% to 20% of at least one polymer chosen from thermoplastic polymers, elastomers and thermoplastic elastomers,
• 80% to 97% of at least one filler chosen from thermally conductive fillers,
• 0% to 2% of one or more additives, or of decomposition residues of the sacrificial phase.

2. Material according to Claim 1, wherein the support made of porous composite material comprises, by weight relative to the total weight of the support:
• 4% to 10% of at least one polymer chosen from thermoplastic polymers, elastomers and thermoplastic elastomers,
• 90% to 96% of at least one filler chosen from thermally conductive fillers,
• 0% to 1% of one or more additives, or of decomposition residues of the sacrificial phase.

3. Material according to Claim 1 or according to Claim 2, wherein the phase-change material forms a continuous phase in the porosity of the support made of porous composite material.

4. Material according to any one of the preceding claims, wherein the polymer phase forming a binder is based on at least one polymer chosen from: polyacrylonitrile, polyolefins, halogenated polymers, acrylic polymers, acrylates, methacrylates, vinyl acetates, polyethers, polyesters, polyamides, aromatic polymers, hydrogenated acrylonitrile-butadiene, ethylene/alkyl acrylate copolymers, polyisoprene, and rubbers.

5. Material according to any one of the preceding claims, wherein the fillers are chosen from: aluminium nitride, boron nitride, magnesium silicon nitride, silicon carbide, diamond, graphite, graphene, carbon nanotubes (CNTs), carbon black, metal fillers such as aluminium, copper or silver, and mixtures thereof.

6. Material according to any one of the preceding claims, wherein the porosity represents at least 40% by volume relative to the total volume of the support made of porous composite material.

7. Material according to any one of the preceding claims, wherein the phase-change material is chosen from hydrocarbon-based chains.

8. Process for producing a material according to any one of Claims 1 to 7, comprising:
- producing a support made of porous composite material comprising at least (A) one polymer phase and (B) one or more fillers chosen from thermally conductive fillers, the production of the support made of porous composite material comprising the following steps:
a) hot-melt mixing of the polymer phase (A), the fillers (B), and a sacrificial polymer phase (C), so as to obtain a mixture,
b) forming of the mixture,
c) eliminating of the sacrificial polymer phase,
- partially or totally filling the porosity of the support made of porous composite material with at least one phase-change material.

9. Process according to Claim 8, wherein the sacrificial polymer phase (C) represents at least 15% by weight, preferably from 20% to 80% by weight of the total weight of the mixture of step a).

10. Process according to either one of Claims 8 and 9, wherein step a) is carried out in an internal mixer or in an extruder.

11. Process according to any one of Claims 8 to 10, wherein step c) is carried out by heat decomposition of the sacrificial polymer phase.

12. Process according to Claim 11, wherein the sacrificial polymer phase is based on at least one polymer chosen from polyalkene carbonates, preferably from polyethylene carbonates and polypropylene carbonates.

13. Process according to any one of Claims 8 to 12, wherein step b) comprises shaping in the form of a film.

14. Process according to any one of Claims 8 to 13, which also comprises a compression step d) at the end of step c).

15. Use of the material according to any one of Claims 1 to 7, or of the material obtained by means of the process according to any one of Claims 8 to 14, in one of the following applications:
- heat dissipator in electronic equipment,
- energy storage support.
